# EUROPEAN PATENT APPLICATION

(11) **EP 4 814 503 A1**
(43) Date of publication of application: **30.09.2026**
(21) Application number: 25167166.5
(22) Date of filing: 28.03.2025
(51) Int. Cl.: G01R 31/00, G01R 31/52

(54) **GROUND FAULT DETECTION APPARATUS**

(71) Applicant: General Electric Company, Cincinnati, Ohio 45215 (US); General Electric Deutschland Holding GmbH, 60313 Frankfurt (DE)
(72) Inventor: RALEV, lliya, Garching (DE); MALI, Rushikesh, Garching (DE); SPAGNOLO, Cosimo, Garching (DE); OSAMA, Mohamed, Garching (DE); HUH, Kum Kang, Evendale, 45215 (US); SPACK, Jeffrey Michael, Evendale (US)
(74) Representative: Openshaw & Co.

(57) **Abstract**

An apparatus for detecting a ground fault of an electric power system (12) of an aircraft (10), the apparatus including a first variable resistor (102) configured to be connected to the electric power system (12), a second variable resistor (104) configured to be connected to the electric power system (12), a switch (110) movable from an open position to a closed position, the switch (110) configured to connect an electrical load (20) to the first variable resistor (102) and the second variable resistor (104) in the closed position, and a controller (112) configured to detect the ground fault based on a first voltage across the first variable resistor (102) when the switch (110) is in the opened position, a second voltage across the second variable resistor (104) when the switch (110) is in the opened position, a third voltage across the first variable resistor (102) when the switch (110) is in the closed position, and a fourth voltage across the second variable resistor (104) when the switch (110) is the closed position.

## Description

### FIELD

The present disclosure relates to an apparatus for detecting a ground fault of an electric power system of an aircraft.

### BACKGROUND

Electrical power distribution systems manage the allocation of power from energy sources to electrical loads that consume distributed electrical power. In aircraft, gas turbine engines for propulsion of the aircraft typically provide mechanical energy that ultimately powers a number of different accessories such as generators, starter/generators, permanent magnet alternators, fuel pumps, and hydraulic pumps, e.g., equipment for functions needed on an aircraft other than propulsion. For example, contemporary aircraft need electrical power for electrical loads related to avionics, motors, and other electric equipment.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1 is a schematic view of an exemplary aircraft with an electric power system.
FIG. 2 is a schematic view of an exemplary ground fault detection apparatus for the electric power system.
FIG. 3 is a schematic view of the exemplary ground fault detection apparatus of FIG. 2 with a switch in a closed position.
FIG. 4 is a block diagram of an exemplary method for determining whether to determine a ground fault.
FIG. 5 is a block diagram of an exemplary method for determining an asymmetric ground fault.
FIG. 6 is a block diagram of an exemplary method for determining a symmetric ground fault.
FIG. 7 is a block diagram of an exemplary controller for the ground fault detection apparatus.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise.

The term "at least one of" in the context of, e.g., "at least one of A, B, and C" refers to only A, only B, only C, or any combination of A, B, and C.

A "ground fault" is a fault caused by degradation of insulation on wires that shorts circuits of an electric power system. A "symmetric" ground fault is a ground fault that occurs on both a positive pole and a negative pole of the electric power system. An "asymmetric" ground fault is a ground fault that occurs on only one of the positive pole or the negative pole of the electric power system.

The present disclosure is generally related to detecting a ground fault for a direct current (DC) electric power system, such as is used in aerospace applications. In an aircraft with a hybrid-electric engine system, the electric power systems may be ungrounded or have a high-resistance grounding. In such a form, electric machines (such as motor/generators) that drive engine systems are connected to electric power sources (such as batteries, fuel cells, and capacitors), reducing fuel consumption of the aircraft.

A single pole insulation degradation has a differential effect and increases voltage stresses on component such as power converters and cables. Double pole insulation degradation has a common mode effect, which may result in a complete short circuit. Early detection of ground faults is limited by conventional overcurrent protection devices due to lower values of fault current on the single pole to ground fault. In particular, an apparatus that can detect both symmetric and asymmetric ground faults is desirable.

Variable resistors allow for voltage measurements to indicate the presence of a ground fault, and a switch to an electrical load allows for a controller to determine whether the ground fault is symmetric or asymmetric. In particular, the voltage measurements, when connected and disconnected from the electrical load, indicate which pole of the electric power system is undergoing the ground fault, and the variable resistors allow for systems with different insulation resistances. By detecting the specific ground fault, repair and maintenance of electric power systems is improved.

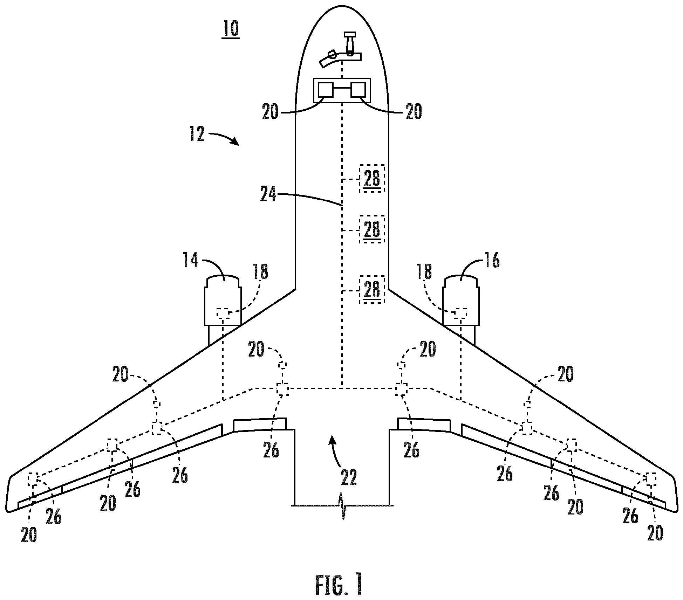

Referring now to the drawings, wherein identical numerals indicate the same elements throughout the figures, FIG. 1 is a schematic illustration of an aircraft 10. The aircraft 10 has an electric power system 12. The electric power system 12 can, for example, include at least one turbine engine, shown as a left engine system 14 and a right engine system 16. The left and right engine systems 14, 16 can be substantially identical, and can further include at least one power source, illustrated respectively as one or more electric machines 18 operating as a motor/generator. At least one of the electric machines 18 can include variable speed or variable output generators. In this example, a variable speed or variable output generator can include a generator adapted or configured to operate within a predetermined range of input speed, gearbox speed ratios, or the like, and can generate a power output within a predetermined output range (e.g. voltage output range, current output range, frequency output range, or a combination thereof). In one non-limiting example, a variable output generator can include a generator adapted or configured to output approximately 115 Volts alternating current (AC) between 390 Hz and 410 Hz.

The aircraft 10 is shown further having one or more power-consuming components, or electrical loads 20, such as for instance, an actuator load, flight critical loads, and non-flight critical loads. The electrical loads 20 are electrically coupled with at least one of the electric machines 18 via a power distribution system 22 including, for instance, one or more transmission lines 24, bus bars, power buses (or the like), and one or more power distribution nodes 26.

The aircraft 10 can further include one or more energy sources 28 selectively connectable with the one or more transmission lines 24, and operable to provide at least a portion of primary power, supplemental power, redundant power, backup power, emergency power, or the like to at least a portion of the aircraft 10. The energy sources 28 may be DC sources of electrical energy that include one or more of: batteries, fuel cells, supercapacitors, or combinations thereof. As shown, the energy sources 28 can provide power to the one or more transmission lines 24, and thus, the one or more power distribution nodes 26 or the one or more electrical loads 20.

In the aircraft 10, the operating left and right engine systems 14, 16 provide mechanical energy which can be extracted, typically via a spool, to provide a driving force for the one or more electric machines 18. The one or more electric machines 18 generate power, such as AC or DC power, and provide the generated power to the transmission lines 24, which delivers the power to the electrical loads 20, positioned throughout the aircraft 10. Furthermore, during operation, the one or more energy sources 28 can be selectively connected with the transmission lines 24, and operable to provide primary or supplemental power to fewer than all of the one or more of the electrical loads 20, i.e., a subset of the electrical loads 20.

Example power distribution management functions can include, but are not limited to, selectively enabling or disabling the delivery of power to particular electrical loads 20, depending on, for example, available power distribution supply, criticality of electrical load functionality, or aircraft mode of operation, such as takeoff, cruise, or ground operations. During emergency or inadequate periods of electrical power generation, including but not limited to engine or generator failure, at least one of one or more energy sources 28 operable to provide supplemental power can be operated, enabled, or connected for providing power to the electrical loads 20. Additional management functions can be included.

It will be understood that while aspects of the disclosure are shown in an aircraft environment of FIG. 1, the disclosure is not so limited and can have applicability in a variety of environments. For example, while this description is directed toward an architecture of the electric power system 12 in the aircraft 10, aspects of the disclosure can be further applicable to provide power, supplemental power, emergency power, essential power, or the like, in otherwise non-emergency operations, such as takeoff, landing, or cruise flight operations.

Furthermore, the number of, and placement of, the various components depicted in FIG. 1 are also non-limiting examples of aspects associated with the disclosure. For example, while various components have been illustrated with relative position of the aircraft 10 (e.g. the one or more electrical loads 20 on the wings of the aircraft 10, etc.), aspects of the disclosure are not so limited, and the components are not so limited based on their schematic depictions.

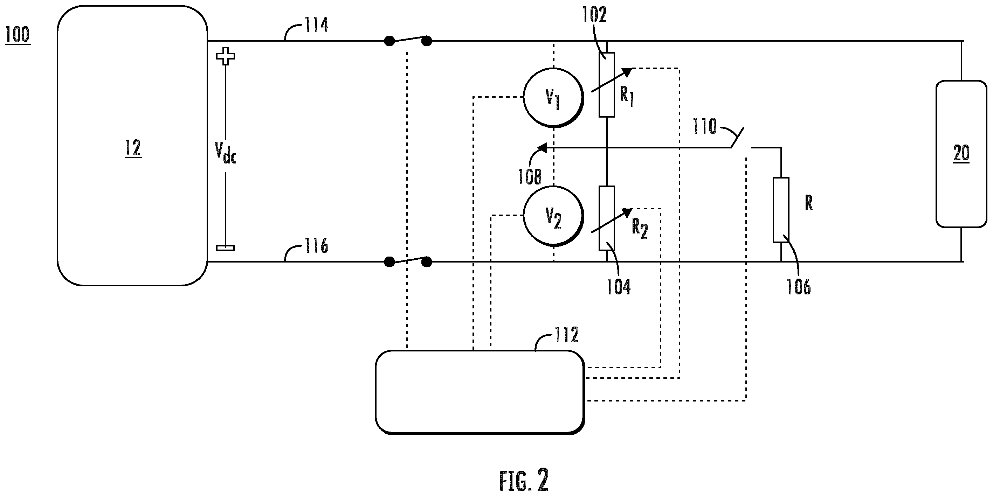

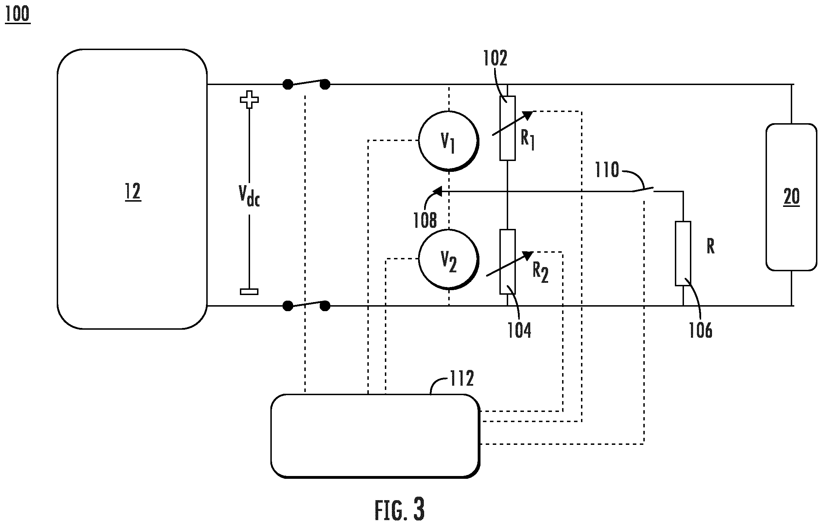

Now referring to FIGS. 2-3, schematic views of an exemplary ground fault detection apparatus 100 are shown. The ground fault apparatus 100 includes a first variable resistor 102 connected to the electric power system 12, a second variable resistor 104 connected to the electric power system 12, an electrical load 20, a fixed resistor 106, a ground 108 disposed between the first variable resistor 102 and the second variable resistor 104, a switch 110 movable from an open position (FIG. 2) to a closed position (FIG. 3), and a controller 112.

The ground fault detection apparatus 100 detects a ground fault for a power source, such as the electric power system 12 of the aircraft 10. The ground fault detection apparatus 100 is configured to detect the ground fault from one or both of a positive pole 114 of the electric power system 12 and a negative pole 116 of the electric power system 12. In particular, an "asymmetric" ground fault is a ground fault on only one of the positive pole 114 or the negative pole 116. A "positive" ground fault is a ground fault on the positive pole 114, and a "negative" ground fault is a ground fault on the negative pole 116. A "symmetric" ground fault is a ground fault on both the positive and negative poles 114, 116.

The first and second variable resistors 102, 104 are resistors that have adjustable resistances. In particular, the first variable resistor 102 has a first resistance adjustable in a range from 50 kiloohms (kΩ) to 300 kΩ, preferably 150 kΩ to 250 kΩ, and the second variable resistor 104 has a second resistance adjustable in a range from 50 kΩ to 300 kΩ. By adjusting the respective resistances of the first and second variable resistors 102, 104, the ground fault detection apparatus 100 can detect whether one or both of the positive pole 114 and the negative pole 116 of the electric power system 12 is undergoing a ground fault. It will be appreciated that the first and second resistances may have ranges outside of the ranges listed herein.

The electrical load 20, as described above, is an electrical draw from one or more components of the aircraft 10 powered by the electric power system 12, such as a fan, a compressor, a turbine, a cockpit display screen, a climate control system, or combinations thereof. The fixed resistor 106 is a resistor with a fixed resistance, i.e., a resistance that is not variable. The switch 110 connects the electrical load 20 to the first variable resistor 102 and the second variable resistor 104 in the closed position (FIG. 3) and disconnects the electrical load 20 from the first variable resistor 102 and the second variable resistor 104 in the open position (FIG. 2).

The controller 112 is configured to detect the ground fault based on data collected from the first variable resistor 102 and the second variable resistor 104. In particular, the controller 112 is configured to determine a first voltage *V*₁ across the first variable resistor 102 when the switch 110 is in the opened position and a second voltage *V*₂ across the second variable resistor 104 when the switch 110 is in the opened position, as shown in FIG. 2. The controller 112 collects first voltage data across the first variable resistor 102 and the ground and second voltage data across the second variable resistor 104 and the ground 108 over a specified period of time. The controller 112 determines the first voltage *V*₁ based on the first voltage data, such as a maximum voltage, a mean voltage, a steady-state voltage, or another conventional method. The controller 112 determines the second voltage *V*₂ based on the second voltage data with a similar method.

In general, the first and second voltages are bounded by a specified voltage output of the electric power system 12, represented at *V_{dc}*. That is, the voltage data may range from negative one-half of the specified voltage output, $- \frac{{V}_{dc}}{2}$, to positive one-half of the specified voltage output, $\frac{{V}_{dc}}{2}$. The positive pole has voltage values from 0 volts (V) to $\frac{{V}_{dc}}{2}$ V, and the negative pole has voltage values from 0 V to $- \frac{{V}_{dc}}{2}$ V. As an example, the electric power system 12 has a specified voltage output of 800V, so the first voltage *V*₁ is in a range from 0 V to 400 V, and the second voltage *V*₂ is in a range from 0 V to -400 V. Based on the first and second voltages *V*₁*,V*₂*,* the controller 112 can determine whether the ground fault is an asymmetric ground fault (i.e., a ground fault for only one of the positive or negative poles 114, 116).

With reference to FIG. 3, the controller 112 determines a third voltage ${V}_{1}^{′}$ across the first variable resistor 102 when the switch 110 is in the closed position and a fourth voltage ${V}_{2}^{′}$ across the second variable resistor 104 when the switch 110 is the closed position. As with the first and second voltages *V*₁*, V*₂, the controller 112 collects third voltage data across the first variable resistor 102 and fourth voltage data across the second variable resistor 104. Because the fixed resistor 106 is part of the circuit of FIG. 3, the third and fourth voltages ${V}_{1}^{′} , {V}_{2}^{′}$ are different than the first and second voltages *V*₁, *V*₂.

The controller 112 is configured to determine a positive insulation resistance *Rₚ* and a negative insulation resistance *Rₙ*. The "positive insulation resistance" *Rₚ* is a measure of the resistance of the positive pole 114 of the electric power system 12, and the "negative insulation resistance" *Rₙ* is a measure of the resistance of the negative pole 116 of the electric power system 12. As described above, when insulation degrades on parts of the electric power system 12, the resulting resistance change generates a ground fault. The positive insulation resistance *Rₚ* and the negative insulation resistance *Rₙ* determine whether the ground fault is a symmetric ground fault (i.e., a ground fault for both the positive and negative poles). The controller 112 determines the positive insulation resistance *Rₚ* and the negative insulation resistance *Rₙ* according to the Expressions below: ${V}_{cm} = \frac{{V}_{1} + {V}_{2}}{2}$ $ρ = {RV}_{1} {V}_{2}^{′} - {RV}_{2} {V}_{1}^{′}$ ${R}_{p} = \left|\frac{{R}_{1} ρ}{ρ + {R}_{1} {V}_{2} {V}_{2}^{′}}\right|$ ${R}_{n} = \left|\frac{{R}_{2} ρ}{ρ + {R}_{2} {V}_{1} {V}_{2}^{′}}\right|$ As will be used later below, a common mode voltage *V_{cm}* is an arithmetic mean of the first voltage *V*₁ and the second voltage *V*₂.

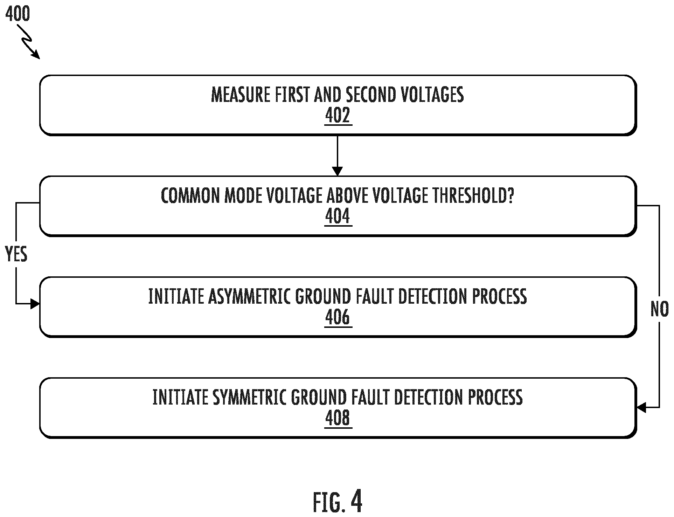

With reference to FIG. 4, a block diagram of an exemplary method 400 for detecting a ground fault of an electric power system for an aircraft is provided. The method 400 may be implemented by a suitable control module, such as a controller of a ground fault detection apparatus, on the aircraft. The method 400 includes at (402) measuring a first voltage across a first variable resistor connected to the electric power system and a second voltage across a second variable resistor connected to the electric power system. The controller collects first voltage data between the first variable resistor and a ground and second voltage data between the second variable resistor and the ground, and the controller determines the first and second voltages based on the first and second voltage data, respectively.

The method 400 includes at (404) determining whether a common mode voltage is above a voltage threshold. As described above, the common mode voltage is the arithmetic mean of the first voltage and the second voltage. The voltage threshold is determined based on empirical and simulation testing of test ground fault detection apparatuses. When the common mode voltage is above the voltage threshold, the method 400 continues (406). Otherwise, the method 400 continues to (408).

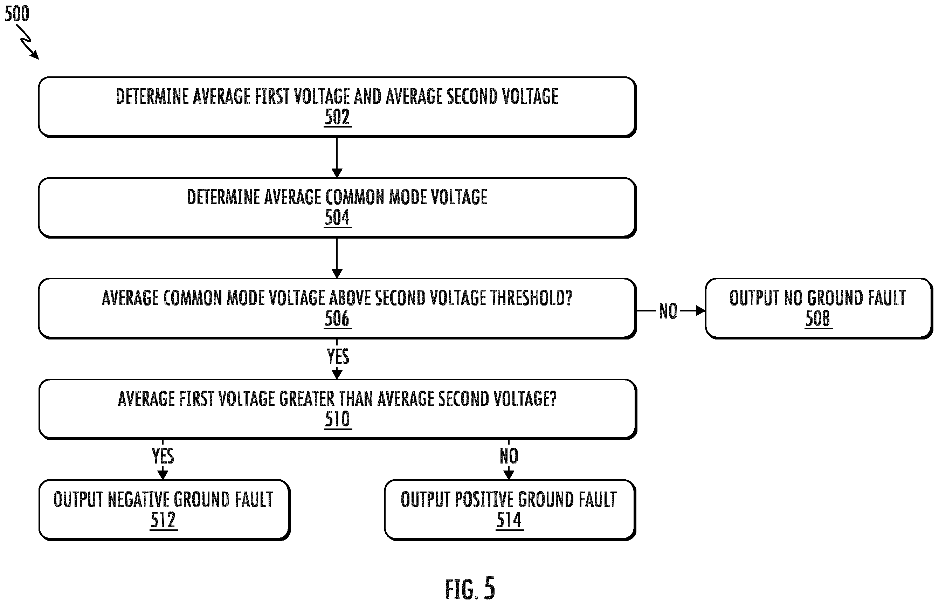

The method includes at (406) initiating an asymmetric ground fault detection process. As described above, the asymmetric ground fault is a ground fault on one of the positive or negative poles of the electric power system. The asymmetric ground fault detection process is described below and shown in FIG. 5.

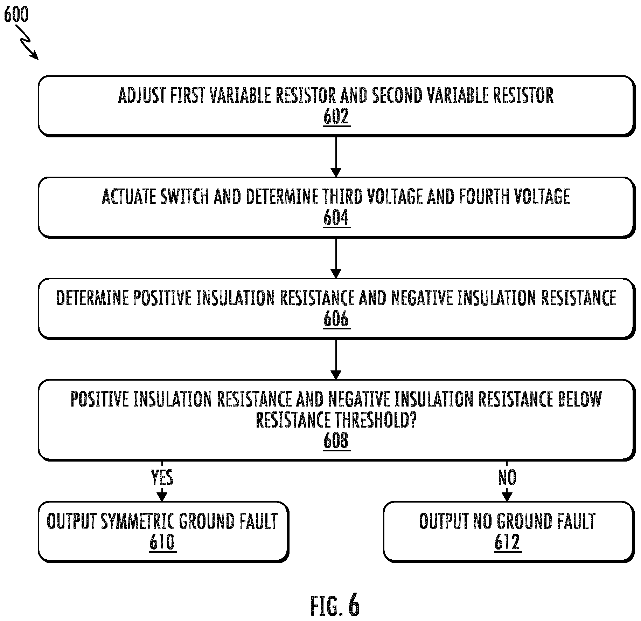

The method includes at (408) initiating a symmetric ground fault detection process. As described above, the symmetric ground fault is a ground fault on both the positive and negative poles of the electric power system. The symmetric ground fault detection process is described below and shown in FIG. 6.

With reference to FIG. 5, a block diagram of a method 500 for detecting an asymmetric ground fault is provided. Specifically, the method 500 is an asymmetric ground fault detection process, described above with respect to step (406) of the method 400. The method 500 may be implemented by a controller of a ground fault detection apparatus.

The method 500 includes at (502) determining an average first voltage and an average second voltage. The "average" first voltage is an arithmetic mean of values of the first voltage data over a specified period of time, such as 1 second. Similarly, the average second voltage is an arithmetic mean of values of the second voltage data over the specified period of time. Because the values of the first and second voltage data may fluctuate over the specified period of time, the average first voltage may differ from the first voltage described above, such as when the first voltage is a maximum value of the first voltage data, and the average second voltage may differ from the second voltage described above.

The method 500 includes at (504) determining an average common mode voltage. The average common mode voltage is an arithmetic mean of the average first voltage and the average second voltage. The average common mode voltage may differ from the common mode voltage described above based on fluctuations of the first and second voltage data over the specified period of time.

The method 500 includes at (506) determining whether the average common mode voltage is above a second voltage threshold. The second voltage threshold is determined based on empirical and simulation testing of test ground fault detection apparatuses. In particular, the second voltage threshold may differ from the voltage threshold described above with respect to the method 400. When the average common mode voltage is above the second voltage threshold, the method 500 continues to the step (510). Otherwise, the method 500 continues to the step (508).

The method 500 includes at (508) outputting no ground fault. When the average common mode voltage is below the second voltage threshold, the controller determines that no ground fault has occurred, and the electric power system is operating within standard parameters.

The method 500 includes at (510) determining whether the average first voltage is greater than the average second voltage. Because the average common mode voltage is above the second voltage threshold, the controller detects an asymmetric ground fault and proceeds to determine whether the asymmetric ground fault is a negative ground fault or a positive ground fault. When the controller determines that the average first voltage is greater than the average second voltage, the method 500 continues to (512), where the controller outputs a negative ground fault. Otherwise, the method 500 continues to (514), where the controller outputs a positive ground fault.

Now referring to FIG. 6, a block diagram of a method 600 for detecting a symmetric ground fault is provided. Specifically, the method 600 is a symmetric ground fault detection process, described above with respect to step (408) of the method 400. The method 600 may be implemented by a controller of a ground fault detection apparatus.

The method 600 includes at (602) adjusting at least one of a first resistance of the first variable resistor or a second resistance of the second variable resistor. By adjusting the first or second resistances, the voltages across the first and second variable resistors change, allowing the controller to determine whether the ground fault is a symmetric ground fault. The controller adjusts the first resistance and/or the second resistance to specified values determined by empirical and simulation testing of test ground fault detection apparatuses.

The method 600 includes at (604) actuating a switch to connect the first variable resistor and the second variable resistor to an electrical load with a fixed resistor, determining a third voltage across the first variable resistor and the electrical load, and determining a fourth voltage across the second variable resistor and the electrical load. The controller collects third voltage data across the first variable resistor and fourth voltage data across the second variable resistor. Because the fixed resistor increases the total resistance of the ground fault detection apparatus 100, creating unbalanced effective ground resistances between the positive pole and the negative pole, the third voltage differs from the first voltage, and the fourth voltage differs from the first voltage.

The method 600 includes at (606) determining a positive insulation resistance and a negative insulation resistance. As described above, the positive insulation resistance and the negative insulation resistance are measures of insulation of the positive and negative poles of the electric power system 12. The controller determines the positive and negative insulation resistances based on the first resistance, the second resistance, the fixed resistor, the first voltage, the second voltage, the third voltage, and the fourth voltage, such as is shown in the Expressions 1-4 above.

The method 600 includes at (608) determining whether both the positive insulation resistance and the negative insulation resistance are below a resistance threshold. The resistance threshold is determined as a resistance at which the insulation of the positive and negative poles are degraded to the point of a ground fault, as determined from empirical and simulation testing of test ground fault detection apparatuses. When the controller determines that both the positive insulation resistance and the negative insulation resistance are below the resistance threshold, the method 600 continues to (610), where the controller outputs a symmetric ground fault. Otherwise, the method 600 continues to (612), where the controller outputs no ground fault.

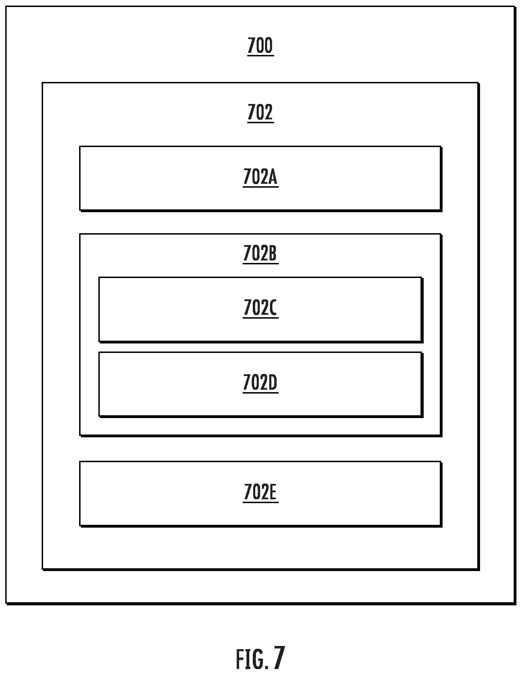

Now referring to FIG. 7, the operation of a controller 700, which may a controller 112 of a ground fault detection apparatus 100 of FIG. 2, will be described. In at least certain embodiments, the controller 700 can include one or more computing devices 702. The computing devices 702 can include one or more processors 702A and one or more memory devices 702B. The one or more processors 702A can include any suitable processing device, such as a microprocessor, microcontroller, integrated circuit, logic device, or other suitable processing device. The one or more memory devices 702B can include one or more computer-readable media, including, but not limited to, non-transitory computer-readable media, RAM, ROM, hard drives, flash drives, or other memory devices.

The one or more memory devices 702B can store information accessible by the one or more processors 702A, including computer-readable instructions 702C that can be executed by the one or more processors 702A. The instructions 702C can be any set of instructions that when executed by the one or more processors 702A, cause the one or more processors 702A to perform operations. In some embodiments, the instructions 702C can be executed by the one or more processors 702A to cause the one or more processors 702A to perform operations, such as any of the operations and functions for which the controller 700 or the computing devices 702 are configured or any other operations or functions of the one or more computing devices 702. The instructions 702C can be software written in any suitable programming language or can be implemented in hardware. Additionally or alternatively, the instructions 702C can be executed in logically or virtually separate threads on the one or more processors 702A. The one or more memory devices 702B can further store data 702D that can be accessed by the one or more processors 702A. For example, the data 702D can include data indicative of power flows, data indicative of engine/ aircraft operating conditions, or any other data or information described herein.

The computing devices 702 can also include a network interface 702E used to communicate, for example, with the other components of the aircraft. For example, in the embodiment depicted, the electric power system may include one or more sensors for sensing data indicative of one or more parameters (e.g., power level, current level, voltage). The controller 700 is operably coupled to the one or more sensors through, e.g., the network interface, such that the controller 700 may receive data indicative of various operating parameters sensed by the one or more sensors during operation. In such a manner, the controller 700 may be configured to operate the electric power system in response to, e.g., the data sensed by the one or more sensors.

The network interface 702E can include any suitable components for interfacing with one or more networks, including for example, transmitters, receivers, ports, controllers, antennas, or other suitable components.

Detecting a ground fault for an electric power system of an aircraft improves repair and maintenance of electric power systems. In particular, distinguishing between symmetric and asymmetric ground faults indicates which components of the electric power system need repair. By using variable resistors and a load resistance to determine different voltages to a ground, the apparatus can identify the specific pole or poles of the electric power system that are undergoing fault. Such an apparatus may be used with different components having different resistances in different aerospace applications, reducing insulation degradation of the components.

Further aspects are provided by the subject matter of the following clauses:
An apparatus for detecting a ground fault of an electric power system of an aircraft includes a first variable resistor configured to be connected to the electric power system, a second variable resistor configured to be connected to the electric power system, a switch movable from an open position to a closed position, the switch configured to connect an electrical load to the first variable resistor and the second variable resistor in the closed position, and a controller configured to detect the ground fault based on a first voltage across the first variable resistor when the switch is in the opened position, a second voltage across the second variable resistor when the switch is in the opened position, a third voltage across the first variable resistor when the switch is in the closed position, and a fourth voltage across the second variable resistor when the switch is the closed position.

The apparatus of any of the preceding clauses, wherein the controller is further configured to determine whether the ground fault is a symmetric ground fault or an asymmetric ground fault based on the first voltage and the second voltage.

The apparatus of any of the preceding clauses, wherein the controller is further configured to determine a common mode voltage based on the first voltage and the second voltage, initiate a symmetric ground fault detection process when the common mode voltage is below a voltage threshold, and initiate an asymmetric ground fault detection process when the common mode voltage is above the voltage threshold.

The apparatus of any of the preceding clauses, wherein the switch is arranged between the first variable resistor and the second variable resistor.

The apparatus of any of the preceding clauses, wherein the electrical load is a component of an aircraft powered by the electric power system.

The system of any of the preceding clauses, wherein the first variable resistor has a first resistance adjustable in a range from 50 kiloohms (kΩ) to 300 kΩ, and the second variable resistor has a second resistance adjustable in a range from 50 kΩ to 300 kΩ.

The system of any of the preceding clauses, wherein the electric power system has a specified voltage output, the first voltage is in a range from 0 volts (V) to positive one-half of the specified voltage output, and the second voltage is in a range from 0 V to negative one-half of the specified voltage output.

The system of any of the preceding clauses, wherein the controller is further configured to determine a positive insulation resistance based on the first variable resistor and a fixed resistor of the electrical load and to determine a negative insulation resistance based on the second variable resistor and the fixed resistor.

The system of any of the preceding clauses, wherein the controller is further configured to detect the ground fault as a symmetric ground fault when both the positive insulation resistance and the negative insulation resistance are below a resistance threshold.

The system of any of the preceding clauses, further including a ground disposed between the first variable resistor and the second variable resistor.

A method for detecting a ground fault of an electric power system of an aircraft includes measuring a first voltage across a first variable resistor connected to the electric power system, measuring a second voltage across a second variable resistor connected to the electric power system, determining a common mode voltage based on the first voltage and the second voltage, initiating a symmetric ground fault detection process when the common mode voltage is below a voltage threshold, and initiating an asymmetric ground fault detection process when the common mode voltage is above the voltage threshold.

The method of any of the preceding clauses, wherein the symmetric ground fault detection process further includes, upon determining that an average of the first voltage and the second voltage is above a voltage threshold, adjusting at least one of a first resistance of the first variable resistor or a second resistance of the second variable resistor.

The method of any of the preceding clauses, wherein the symmetric ground fault detection process further includes, after adjusting the first resistance or the second resistance, actuating a switch to connect the first variable resistor and the second variable resistor to an electrical load and a fixed resistor, determining a third voltage across the first variable resistor and the electrical load, determining a fourth voltage across the second variable resistor and the electrical load, and detecting the ground fault based on the first voltage, the second voltage, the third voltage, and the fourth voltage.

The method of any of the preceding clauses, wherein the symmetric ground fault detection process further includes determining a positive insulation resistance based on the first variable resistor and the fixed resistor, and determining a negative insulation resistance based on the second variable resistor and the fixed resistor.

The method of any of the preceding clauses, wherein the positive insulation resistance is further based on the first voltage, the second voltage, the third voltage, and the fourth voltage, and the negative insulation resistance is further based on the first voltage, the second voltage, the third voltage, and the fourth voltage.

The method of any of the preceding clauses, wherein the symmetric ground fault detection process further includes detecting the ground fault as a symmetric ground fault when both the positive insulation resistance and the negative insulation resistance are below a resistance threshold.

The method of any of the preceding clauses, wherein the asymmetric ground fault detection process further includes collecting first voltage data across the first variable resistor over a period of time and collecting second voltage data across the second variable resistor over the period of time.

The method of any of the preceding clauses, wherein the asymmetric ground fault detection process further includes determining a second common mode voltage as an average of the first voltage data and the second voltage data and detecting the ground fault as an asymmetric ground fault when the second common mode voltage is above a second voltage threshold.

The method of any of the preceding clauses, wherein the asymmetric ground fault detection process further includes determining a positive insulation resistance based on the first variable resistor and a fixed resistor connected to the first variable resistor and to the second variable resistor, determining a negative insulation resistance based on the second variable resistor and the fixed resistor, detecting the ground fault as a positive ground fault when the positive insulation resistance is less than the negative insulation resistance, and detecting the ground fault as a negative ground fault when the positive insulation resistance is greater than the negative insulation resistance.

An aircraft includes an electric power system, an electrical load, a fixed resistor, and an apparatus for detecting a ground fault of the electric power system, the apparatus including a first variable resistor connected to the electric power system, a second variable resistor connected to the electric power system, a switch movable from an open position to a closed position, the switch configured to connect the electrical load and the fixed resistor to the first variable resistor and the second variable resistor in the closed position, and a controller configured to detect the ground fault based on a first voltage across the first variable resistor when the switch is in the opened position, a second voltage across the second variable resistor when the switch is in the opened position, a third voltage across the first variable resistor when the switch is in the closed position, and a fourth voltage across the second variable resistor when the switch is the closed position.

An aircraft includes an electric power system, an electrical load, a fixed resistor, and an apparatus according to any preceding clause.

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. An apparatus for detecting a ground fault of an electric power system (12) of an aircraft (10), the apparatus comprising:
a first variable resistor (102) configured to be connected to the electric power system (12);
a second variable resistor (104) configured to be connected to the electric power system (12);
a switch (110) movable from an open position to a closed position, the switch (110) configured to connect an electrical load (20) to the first variable resistor (102) and the second variable resistor (104) in the closed position; and
a controller (112) configured to detect the ground fault based on a first voltage across the first variable resistor (102) when the switch (110) is in the opened position, a second voltage across the second variable resistor (104) when the switch (110) is in the opened position, a third voltage across the first variable resistor (102) when the switch (110) is in the closed position, and a fourth voltage across the second variable resistor (104) when the switch (110) is the closed position.

2. The apparatus of any of the preceding claims, wherein the controller (112) is further configured to determine whether the ground fault is a symmetric ground fault or an asymmetric ground fault based on the first voltage and the second voltage.

3. The apparatus of any of the preceding claims, wherein the controller (112) is further configured to:
determine a common mode voltage based on the first voltage and the second voltage;
initiate a symmetric ground fault detection process when the common mode voltage is below a voltage threshold; and
initiate an asymmetric ground fault detection process when the common mode voltage is above the voltage threshold.

4. The apparatus of any of the preceding claims, wherein the switch (110) is arranged between the first variable resistor (102) and the second variable resistor (104).

5. The apparatus of any of the preceding claims, wherein the electrical load (20) is a component of an aircraft (10) powered by the electric power system (12).

6. The apparatus of any of the preceding claims, wherein the first variable resistor (102) has a first resistance adjustable in a range from 50 kiloohms (kΩ) to 300 kΩ, and the second variable resistor (104) has a second resistance adjustable in a range from 50 kΩ to 300 kΩ.

7. The apparatus of any of the preceding claims, wherein the electric power system (12) has a specified voltage output, the first voltage is in a range from 0 volts (V) to positive one-half of the specified voltage output, and the second voltage is in a range from 0 V to negative one-half of the specified voltage output.

8. The apparatus of any of the preceding claims, wherein the controller (112) is further configured to determine a positive insulation resistance based on the first variable resistor (102) and a fixed resistor (106) of the electrical load (20) and to determine a negative insulation resistance based on the second variable resistor (104) and the fixed resistor (106).

9. An aircraft (10) comprising:
an electric power system (12);
an electrical load (20);
a fixed resistor (106); and
the apparatus of any of the preceding claims.

10. A method (400, 500, 600) for detecting a ground fault of an electric power system (12) of an aircraft (10), the method (400, 500, 600) comprising:
measuring a first voltage across a first variable resistor (102) connected to the electric power system (12);
measuring a second voltage across a second variable resistor (104) connected to the electric power system (12);
determining a common mode voltage based on the first voltage and the second voltage;
initiating a symmetric ground fault detection process when the common mode voltage is below a voltage threshold; and
initiating an asymmetric ground fault detection process when the common mode voltage is above the voltage threshold.

11. The method (400, 500, 600) of any of the preceding claims, wherein the symmetric ground fault detection process further comprises, upon determining that an average of the first voltage and the second voltage is above a voltage threshold, adjusting at least one of a first resistance of the first variable resistor (102) or a second resistance of the second variable resistor (104).

12. The method (400, 500, 600) of any of the preceding claims wherein the symmetric ground fault detection process further comprises, after adjusting the first resistance or the second resistance:
actuating a switch (110) to connect the first variable resistor (102) and the second variable resistor (104) to an electrical load (20) and a fixed resistor (106);
determining a third voltage across the first variable resistor (102) and the electrical load (20);
determining a fourth voltage across the second variable resistor (104) and the electrical load (20); and
detecting the ground fault based on the first voltage, the second voltage, the third voltage, and the fourth voltage.

13. The method (400, 500, 600) of any of the preceding claims, wherein the asymmetric ground fault detection process further comprises collecting first voltage data across the first variable resistor (102) over a period of time and collecting second voltage data across the second variable resistor (104) over the period of time.

14. The method (400, 500, 600) of any of the preceding claims, wherein the asymmetric ground fault detection process further comprises determining a second common mode voltage as an average of the first voltage data and the second voltage data and detecting the ground fault as an asymmetric ground fault when the second common mode voltage is above a second voltage threshold.

15. The method (400, 500, 600) of any of the preceding claims, wherein the asymmetric ground fault detection process further comprises:
determining a positive insulation resistance based on the first variable resistor (102) and a fixed resistor (106) connected to the first variable resistor (102) and to the second variable resistor (104);
determining a negative insulation resistance based on the second variable resistor (104) and the fixed resistor (106);
detecting the ground fault as a positive ground fault when the positive insulation resistance is less than the negative insulation resistance; and
detecting the ground fault as a negative ground fault when the positive insulation resistance is greater than the negative insulation resistance.
